# EUROPEAN PATENT APPLICATION

(11) **EP 1 835 344 A1**
(43) Date of publication of application: **19.09.2007**
(21) Application number: 05822681.2
(22) Date of filing: 28.12.2005
(51) Int. Cl.: G03F 7/075, G02B 5/20, G03F 7/004, G03F 7/038, G11C 11/42, H01L 21/027, H01L 21/336, H01L 29/786

(54) **SILICON-CONTAINING PHOTOSENSITIVE COMPOSITION, METHOD FOR FORMING THIN FILM PATTERN USING SAME, PROTECTIVE FILM FOR ELECTRONIC DEVICE, GATE INSULATING FILM AND THIN FILM TRANSISTOR**

(30) Priority: 05.01.2005 JP 2005000833; 08.07.2005 JP 2005200144; 04.08.2005 JP 2005227091
(71) Applicant: SEKISUI CHEMICAL CO., LTD., Osaka-shi, Osaka 530-8565 (JP); Matsukawa, Kimihiro, Tondabayashi-shi, Osaka 584-0073 (JP); Matsuura, Yukihito, Nara-shi, Nara 631-0061 (JP)
(72) Inventor: MATSUKAWA, Kimihiro, Tondabayashi-city, Osaka 584-0073 (JP); MATSUURA, Yukihito, Nara-city, Nara 631-0061 (JP); AZUMA, Kenichi, c/o SEKISUI CHEMICAL CO.LTD.,, Osaka; 618-8589 (JP); NAKAMURA, Shigeru, c/o SEKISUI CHEMICAL CO.LTD.,, Osaka; 618-8589 (JP); KUSAKA, Yasunari, c/o SEKISUI CHEMICAL CO.LTD.,, Osaka; 618-8589 (JP)
(74) Representative: Merkle, Gebhard
(86) International application number: PCT/JP2005/024090
(87) International publication number: WO 2006/073115

(57) **Abstract**

Disclosed is a photosensitive composition having photosensitivity which is alkaline developable without containing a crosslinking agent. Specifically disclosed is a silicon-containing photosensitive composition **characterized by** containing a silicon-containing polymer including at least one polymer (A1) represented by the general formula (1) below, wherein at least one of R₁₁ - R₁ₙ is an H and the rest of them are organic groups, or at least one polymer (A1) and one polymer (A2) represented by the general formula (2) below, and a compound (B) which generates an acid or a base when irradiated with an active ray or radiation ray. 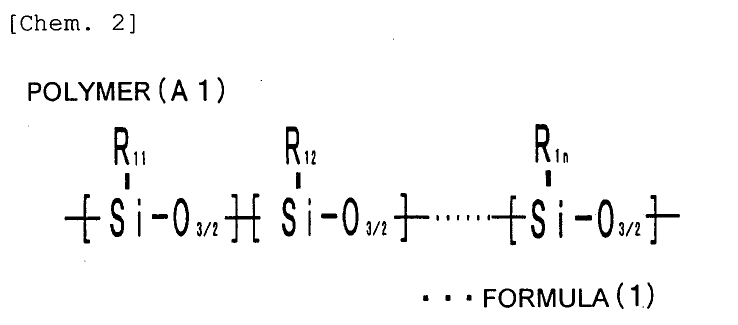 (In the formula, at least one of R₁₁ - R₁ₙ represents an H, and n represents an integer of 1 or more.) 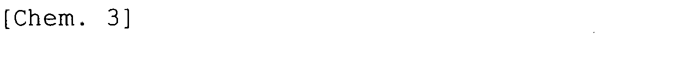 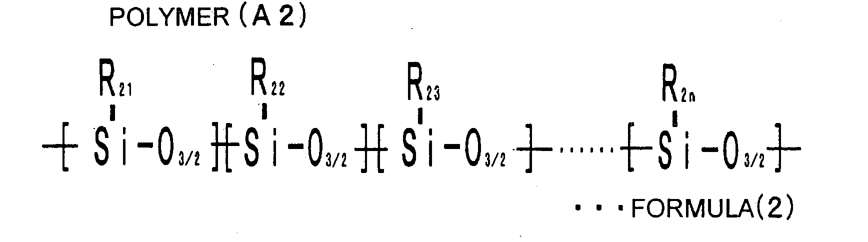 (In the formula, R₂₁ - R₂ₙ represent atoms other than H or functional groups, and n represents an integer of 1 or more.)

## Description

### TECHNICAL FIELD

The present invention relates to a silicon-containing photosensitive composition having photosensitivity which enables to form a pattern by alkaline development, a method for forming a thin film pattern using the same, a protective film for electronic devices, a gate insulating film and a thin film transistor.

### BACKGROUND ART

In the production of semiconductor devices, liquid crystal display devices, printed circuit boards, and the like, various members including a protective film and an interlayer insulation film are formed by a method of forming a minute pattern. In recent years, the trend of finer patterns is further growing as highly integrated devices increase. Therefore, methods of forming a thin film pattern, using photolithography technology, are widely used, and an attempt is made to apply light with a shorter wavelength for exposure in order to form further a finer pattern.

In Patent Document 1 listed below, a method of forming a pattern by a photolithography process, which uses a photosensitive composition containing 10 to 90% by weight of a poly(silsesquioxane) compound expressed by the following structural formula (X), 0.01 to 20% by weight of a compound which can generate a strong acid when irradiated with an active ray or radiation ray, and 5 to 60% by weight of a crosslinking agent, is disclosed.

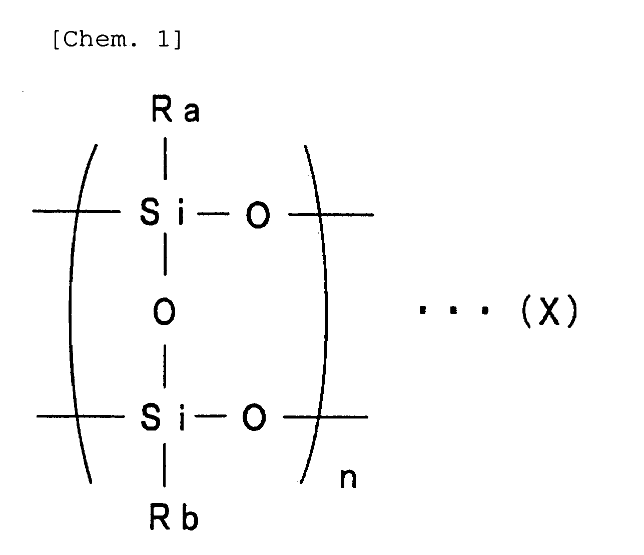

In addition, it is said that in the general formula (X), Ra and Rb are the same or different organic groups, n is a polymerization degree, and the above-mentioned Ra and Rb are preferably phenolic hydroxyl groups.

It is said that the above-mentioned photosensitive composition described in Patent Document 1 can form a minute pattern using light with a short wavelength because it uses the above-mentioned specific poly(silsesquioxane) compound (X).

However, in a method of forming a pattern which uses the photosensitive composition described in Patent Document 1 as described above, the photosensitive composition contains not onlypoly(silsesquioxane) compound (X) andaphotoacidgenerator which generates an acid by irradiation of light, but also a crosslinking agent to crosslink the poly(silsesquioxane) compound (X) in order to form an alkali-insoluble portion. That is, a crosslinking agent consisting of aliphatic alcohols such as 2,5-dimethyl-2,5-hexanediol, erythritol or pentaerythritol, a methylol-containing melamine compound or an alkyl ether-containing melamine compound, and the like was mixed in an amount about 5 to 95 parts by weight with respect to 100 parts by weight of a resin.
Patent Document 1: Japanese Unexamined Patent Publication No.10-268520

### DISCLOSURE OF THE INVENTION

In the area of electronic components such as semiconductor devices, it is preferred that a photosensitive composition for preparing a thin film pattern does not contain impurities as far as possible. That is, if impurities such as the above-mentioned crosslinking agent remain, the thin film patternobtainedmaybecolored, ormechanicalstrength, electric properties or the like of the thin f ilmpattern may be deteriorated. Also, there is a probability that the above crosslinking agent is vaporized by heating or the like in the subsequent process step, and thereby characteristics of the thin film pattern are fluctuated. Therefore, there might be cases where it becomes difficult to satisfy heat resistance, transparency, and weather resistance which are necessary for, for example, interlayer insulation films of the semiconductor devices.

In view of the above state of the prior art, it is an object of the present invention to provide a silicon-containing photosensitive composition having photosensitivity which is developable without using a crosslinking agent, a method for forming a thin film pattern using the same, a protective film for electronic devices, an electronic device, a gate insulating film and a thin film transistor.

In accordance with a broad aspect of the present invention, provided is a silicon-containing photosensitive composition characterized by containing at least one silicon-containing polymer (A1) having a structure represented by the general formula (1) below, wherein at least one of R₁₁ to R₁ₙ is H, and a compound (B) which generates an acid or a base when irradiated with an active ray or radiation ray.

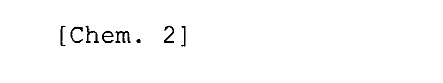

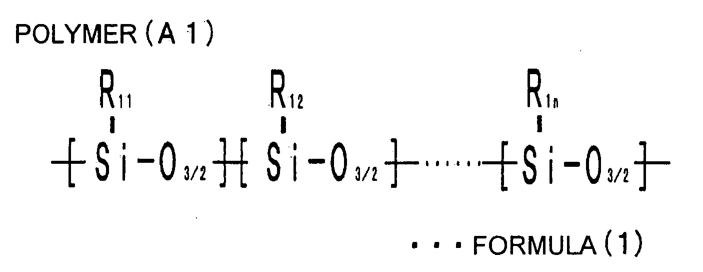

In the formula, at least one of R₁₁ to R₁ₙ represents H, and n represents an integer of 1 or more.

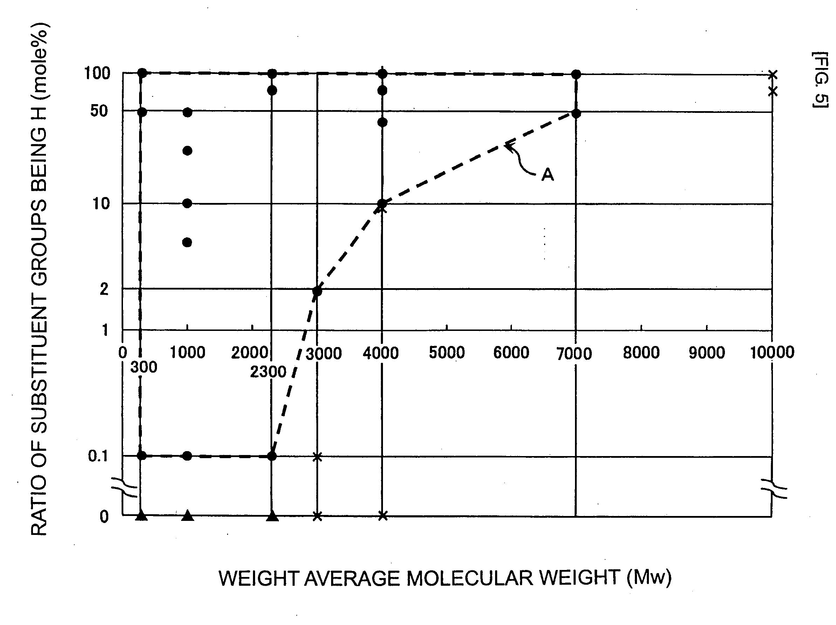

In a specific aspect of the present invention, when a weight average molecular weight of the above-mentioned silicon-containing polymer (A1) is denoted by Mw and the total of substituent groups R₁₁ to R₁ₙ in the foregoing silicon-containing polymer (A1) is regarded as 100 mole%, a ratio of substituent groups being H is adapted to fall within an area enclosed by a broken line A in Fig. 5 described later, depending on the weight average molecular weight Mw.
In another specific aspect of the present invention, at least one polymer (A2) represented by the general formula (2) below, in which each of groups R₂₁ to R₂ₙ is an atom other than H (hydrogen) or a functional group, is further contained.

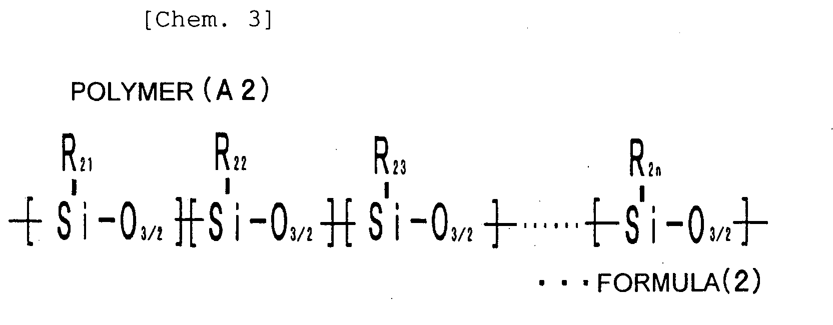

In the formula, each of groups R₂₁ to R₂ₙ represents an atom other than H or a functional group, and n represents an integer of 1 or more.

In the case where both the above silicon-containing polymer (A1) and the above silicon-containing polymer (A2) are contained in the silicon-containing photosensitive composition of the present invention, a weight average molecular weight of the silicon-containing polymer (A1) and the silicon-containing polymer (A2) is denoted by Mw and the total of substituent groups R₁₁ to R₁ₙ and substituent groups R₂₁ to R₂ₙ in the foregoing silicon-containing polymer (A1) and silicon-containing polymer (A2) is regarded as 100 mole%, preferably, a ratio of substituent groups being H is adapted to fall within an area enclosed by a broken line A in Fig. 5, depending on the weight average molecular weight Mw.

A method of producing a thin film pattern of the present invention comprises the steps of forming a photosensitive composition layer consisting of the silicon-containing photosensitive composition composed according to the present invention on a substrate, exposing selectively the foregoing photosensitive composition layer with an active ray or radiation ray in accordance with a pattern to be formed to form a latent image in the form of the pattern, and developing the foregoing photosensitive composition layer on which the foregoing latent image is formed with a developer to obtain a thin film pattern.
A thin film formed by using the silicon-containing photosensitive composition of the present invention is used for various applications.. Herein, "A thin film formed by using the silicon-containing photosensitive composition" refers to a thin film obtained by giving energy such as heat or light to the silicon-containing photosensitive composition to introduce a crosslinking structure. In a specific aspect of the present invention, the above-mentioned thin film is used as a protective film for electronic devices, and a transistor, a color filter, an organic EL device, and the like having such a protective film, can be provided according to the present invention.
Further, the above-mentioned thin film is suitably used as a gate insulating film or passivation film of a thin film transistor. Thin film transistor having such a gate insulating film and/or passivation film can also be provided according to the present invention.

Hereinafter, the present invention will be described in detail.
In order to achieve the above-mentioned issues, the present inventors made earnest investigations, and consequently they have found that by employing specific poly(silsesquioxane) compound, a photosensitive composition which is developable without using a crosslinking agent can be provided, and have completed the present invention.

In the present invention, at least one kind of the above-mentioned silicon-containing polymer (A1) is used.
That is, the silicon-containing polymer (A1) has a structure in which at least one of R₁₁ to R₁ₙ is H in the following general formula (1).

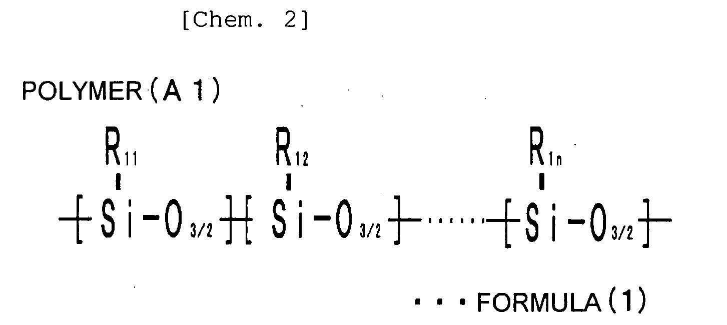

Therefore, when all of substituent groups R₁₁ to R₁ₙ are H in the silicon-containing polymer (A1), the silicon-containing polymer (A1) is a polymer having a skeleton comprising

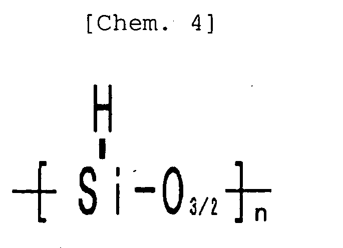

Further, in the silicon-containing polymer (A1), substituent groups R₁₁ to R₁ₙ may be the same or may be different.

Further, in the present invention, at least one kind of this silicon-containing polymer (A1) is mixed in the silicon-containing photosensitive composition, and hence two or more kinds of silicon-containing polymer (A1) may be contained.
As described above, since at least one of substituent groups R₁₁ to R₁ₙ is H in the silicon-containing polymer (A1), the silicon-containing polymer (A1) has a -SiH group. The -SiH group readily reacts with a water content in air by the action of an acid or a base produced from the compound (B) by irradiation of an active ray or radiation ray. As a result of this, a -SiH group of the silicon-containing polymer (A1) and a -SiH group of an adjacent silicon-containing polymer (A1) readily react with a water content (H₂O) in air, and a Si-O-Si bond is produced and crosslinking proceeds, and therefore the silicon-containing photosensitive composition becomes insoluble in a developer. That is, since R₁ and/or R₂ has a -SiH group, the -SiH group reacts with a water content in air without using a crosslinking agent and therefore crosslinking proceeds to form an insoluble portion. Accordingly, in accordance with the present invention, use of the crosslinking agent can be eliminated.

Substituent groups R₁₁ to R₁ₙ which are not H in the above silicon-containing polymer (A1) is not particularly limited, and examples of the substituent groups include organic groups such as substituted or unsubstituted aliphatic hydrocarbon groups, substituted or unsubstituted alicyclic hydrocarbon groups, substituted or unsubstituted aromatic hydrocarbon groups and substituted or unsubstituted polar group-containing organic groups. Examples of such organic groups include, more specifically, substituted or unsubstituted aliphatic hydrocarbon groups such as a methyl group, an n-propyl group, an n-butyl group, an n-hexyl group, a phenylmethyl group, a trifluoropropyl group and a nonafluorohexyl group; substituted or unsubstituted aromatic hydrocarbon groups such as a cyclohexyl group and a methylcyclohexyl group; substituted or unsubstituted aromatic hydrocarbon groups such as a p-tolyl group, a biphenyl group and a phenyl group; and substituted or unsubstituted polar group-containing organic groups such as a hydroxyl-containing group, a carboxyl group and a phenolic hydroxyl-containing group.
Substituent groups R₁₁ to R₁ₙ may be a functional group or an atom other than organic groups. Example of such an atom or a functional group include halogens such as fluorine and chlorine, a halide group, a hydroxyl group, an alkoxide group, an amino group, a nitro group, a sulfoxide group, and a nitrile group. As for R₁₁ to R₁ₙ, the organic groups, these atoms and functional groups may be mixed.

Furthermore, in the general formula (1), a structure of a skeleton having a siloxane group is not particularly limited and may be any one of a random type, a ladder type, or a basket type. Further, two or more kinds of polymers having various structures such as the random type, the ladder type, and the basket type may be used together.

Further, in the present invention, at least one silicon-containing polymer (A2) represented by the following general formula (2) may be further contained in addition to the above-mentioned silicon-containing polymer (A1).

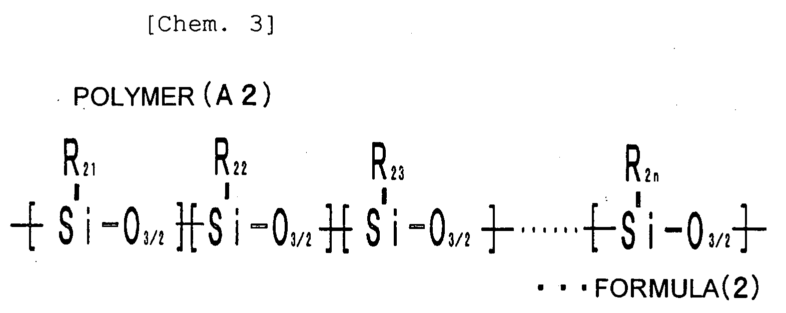

In the silicon-containing polymer (A2), all of substituent groups R₂₁ to R₂ₙ are an atom other than H or a functional group, and n is an integer of 1 or more. Examples of the atoms other than H or the functional groups include the same atoms other than H and the same functional groups such as organic groups as in the silicon-containing polymer (A1) described above. In the silicon-containing polymer (A2), substituent groups R₂₁ to R₂ₙ may be the same or may be different. Further, in the present invention, two or more kinds of the above-mentioned silicon-containing polymer (A2) may be contained.

When the silicon-containing polymer (A1) is produced, generally, the silicon-containing polymer (A2) is often also produced as a by-product. Accordingly, in the present invention, the silicon-containing polymer (A2) is often further contained in addition to the silicon-containing polymer (A1). However, the silicon-containing polymer (A2) doesn't have to be necessarily contained.

When the silicon-containing polymer (A2) is contained in addition to the silicon-containing polymer (A1), the content thereof is desirably small since the silicon-containing polymer (A2) does not have a SiH group and hardly cross-links without a crosslinking agent. More specifically, when the silicon-containing polymer (A1) and the silicon-containing polymer (A2) are contained, it is preferred to mix in the proportions of 400 parts by weight or less of the silicon-containing polymer (A2) to 100 parts by weight of the silicon-containing polymer (A1).

In the present invention, in the case where the silicon-containing photosensitive composition contains only the silicon-containing polymer (A1) without containing the silicon-containing polymer (A2) as a silicon-containing polymer, a ratio of substituent groups being H in substituent groups R₁₁ to R₁ₙ is adapted to fall within an area enclosed by a broken line A in Fig.5 when the total of substituent groups R₁₁ to R₁ₙ is regarded as 100 mole% and a weight average molecular weight of the silicon-containing polymer (A1) is denoted by Mw. In the area other than an area enclosed by a broken line A, since an amount of a SiH group is small, crosslinking by virtue of production of a Si-O-Si bond becomes hard to proceed.

In the present invention, in the case where the silicon-containing polymer (A2) is contained in addition to the silicon-containing polymer (A1), when the total of substituent groups R₁₁ to R₁ₙ and substituent groups R₂₁ to R₂ₙ is regarded as 100 mole% and a weight average molecular weight of a mixture of the silicon-containing polymer (A1) and the silicon-containing polymer (A2) is denoted by Mw, preferably, a ratio of substituent groups being H in the substituent groups R₁₁ to R₁ₙ and the substituent groups R₂₁ to R₂ₙ is adapted to fall within an area enclosed by a broken line A in Fig.5. In an area outside this area, crosslinking by virtue of production of a Si-O-Si bond becomes hard to proceed.
In any case, when the silicon-containing photosensitive composition falls within an area enclosed by a broken line A in Fig. 5, the Si-O-Si bond is promptly produced and crosslinking proceeds according to the present invention.

In addition, for example when a content by weight of the silicon-containing polymer (A1) is denoted by x(%), the content by weight of the silicon-containing polymer (A2) is denoted by Y(%), a weight average molecular weight of the silicon-containing polymer (A1) is denoted by MA1, and a weight average molecular weight of the silicon-containing polymer (A2) is denoted by MA2, a weight average molecular weight of the above-mentioned mixture is expressed by (x•MA1+Y•MA2)/100.

The compound (B) used in the present invention is a compound which generates an acid or a base when irradiated with an active ray or radiation ray. Such a compound is not particularly limited, and examples of the compounds to generate an acid include an onium salt and the like. More specific examples of the compounds include a salt of diazonium, phosphonium, or iodonium with BF₄⁻, PF₆⁻, SBF₆⁻, or ClO₄⁻ , organic halogen, organic metals, and organic halides. Furthermore specifically, examples of the compounds to generate an acid include sulfonium salt compounds such as triphenylsulfonium trifluoromethanesulfonate, triphenylsulfonium trifluoromethaneantimonate, triphenylsulfonium benzosulfonate, cyclohexylmethyl(2-oxocyclohexyl)sulfonium trifluoromethanesulfonate, dicyclohexyl(2-oxocyclohexyl)sulfonium trifluoromethanesulfonate, dicyclohexylsulfonyl cyclohexanone and dimethyl(2-oxocyclohexyl)sulfonium trifluoromethanesulfonate, iodonium salts such as diphenyliodonium trifluoromethanesulfonate, and N-hydroxy-succinimide trifluoromethanesulfonate, but the compound to generate an acid is not limited to these compounds.

The above-mentioned compounds (B) which generate an acid when irradiated with an active ray or radiation ray may be used alone or in combination of two or more kinds thereof.
The above-mentioned compounds which generates an acid when irradiated with an active ray or radiation ray are not particularly limited, but at least one compound selected from the group consisting of highly reactive onium salt, diazonium salt, and sulfonic acid ester is preferably used.

The content of the above-mentioned compound to generate an acid is desirably within a range of 0. 05 to 50 parts by weight with respect to 100 parts by weight of a resin content which is the total of the above-mentioned silicon-containing polymer (A1) and the above-mentioned silicon-containing polymer (A2) to be added as required. That is, the above-mentioned compound to generate an acid is desirably added in the proportions of 0.5 to 30 parts by weight of this compound to 100 parts by weight of the resin content. When the proportion of this compound is less than 0.05 parts by weight, the sensitivity may be insufficient and the formation of a thin film pattern may become difficult, and when the proportion of this compound is more than 50 parts by weight, it may become difficult to apply the photosensitive composition uniformly and further it may become apt to produce a residue after development.

In addition to these sensitizers, a sensitizer may be further added in order to increase the sensitivity further. Suitable sensitizers are specifically benzophenone, p,p'-tetramethyldiaminobenzophenone, p,p'-tetraethylaminobenzophenone, 2-chlorothioxanthone, anthrone, 9-ethoxyanthracene, anthracene, pyrene, perylene, phenothiazine, benzyl, acridine orange, benzoflavine, setoflavine-T, 9,10-diphenylanthracene, 9-fluorenone, acetophenone, phenanthrene, 2-nitrofluorene, 5-nitroacenaphthene, benzoquinone, 2-chloro-4-nitroaniline, N-acetyl-p-nitroaniline, p-nitroaniline, N-acetyl-4-nitro-1-naphthylamin picramide, anthraquinone, 2-ethylanthraquinone, 2-tert-butylanthraquinone, 1,2-benzanthraquinone, 3-methyl-1, 3- diaza-1,9-benzanthrone, dibenzalacetone, 1,2-naphthoquinone, 3,3'-carbonyl-bis(5,7-dimethoxycarbonylcoumarin) and coronene, but they are not limited to these.

In the present invention, a compound which generates a base when irradiated with an active ray or radiation ray may be used as the compound (B). Examples of such a compound to generate a base include a cobalt-amine complex, o-acyloxime, carbamic acid derivatives, formamide derivatives, quaternary ammonium salt, tocyl amine, carbamate, and an amine imide compound. Specifically, 2-nitrobenzylcarbamate, 2,5-dinitrobenzylcyclohexylcarbamate, N-cyclohexyl-4-methylphenylsulfonamide, and 1,1-dimethyl-2-phenylethyl-N-isopropylcarbamate can be suitably used.

As the above-mentioned compound (B) to generate a base, preferably, an amine imide compound which generates a base when irradiated with an active ray or radiation ray is suitably used. Such the amine imide compound is not particularly limited as long as it generates a base when irradiated with an active ray or radiation ray. Examples of such the amine imide compound include compounds expressed by the general formula (3) or (4) below.

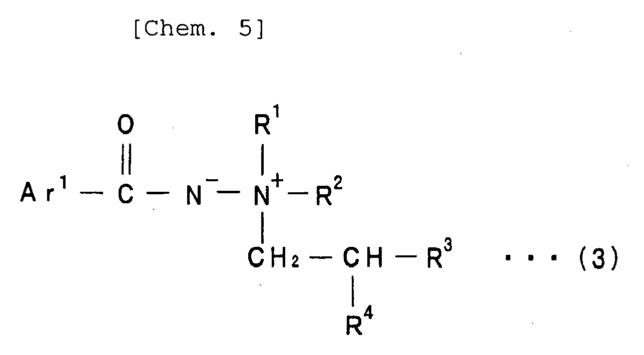

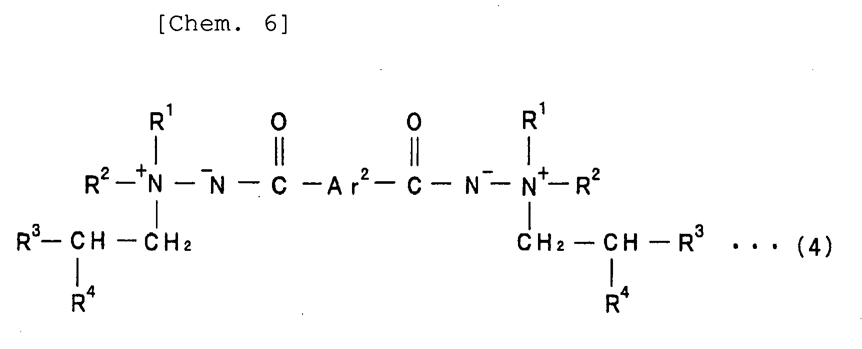

Further, in the general formulas (3) and (4), R¹, R², R³ are independent from each other and represent hydrogen, an alkyl group having 1 to 8 carbon atoms, an alkoxy group having 1 to 8 carbon atoms, an alkylidene group having 1 to 8 carbon atoms, a cycloalkyl group having 4 to 8 carbon atoms, a cycloalkenyl group having 4 to 8 carbon atoms, a phenoxyalkyl group having 1 to 6 carbon atoms, a phenyl group, an electron-donating group- and/or an electron-attractive group-substituted phenyl group, a benzyl group, and an electron-donating group- and/or an electron-attractive group-substituted benzyl group. Examples of the alkyl group having 1 to 8 carbon atoms include an alkyl group having a substituent, for example, an isopropyl group, an isobutyl group, a t-butyl group, in addition to a straight chain alkyl group. Among these substituents, the alkyl group having 1 to 8 carbon atoms, the cycloalkyl group having 6 to 8 carbon atoms, and the phenoxyalkyl group having 1 to 6 carbon atoms are preferred from the viewpoint of simplicity of synthesis and solubility of amine imide. Further, R⁴ independently represents an alkyl group having 1 to 5 carbon atoms, a hydroxyl group, a cycloalkyl group having 4 to 8 carbon atoms, an alkoxy group having 1 to 5 carbon atoms, and a phenyl group. Ar¹ in the above general formula (3) is an aromatic group, and such an amine imide compound is known prior to the present application as disclosed in, for example, Japanese Unexamined Patent Publication No. 2003-35949, and it is commonly available. In the above general formula (4), Ar² is an aromatic group.

The above-mentioned amine imide compound has high efficiency of generating a base compared with a compound which generates a primary amine or a secondary amine when irradiated with an active ray or radiation ray. Therefore, the above-mentioned amine imide compound can reduce an exposure time, and consequently it can shorten a production process, and it is thus desirable.
The above compounds (B) to generate a base may be used alone or in combination of two or more kinds thereof. Further, generally, the content of the compounds (B) to generate a base is desirably within a range of 0.05 to 50 parts by weight with respect to 100 parts by weight of the above-mentioned resin content. When this content is less than 0.05 parts by weight, the sensitivity is deteriorated and the formation of a thin film pattern may become difficult. When the content is more than 50 parts by weight, it may become difficult to apply the photosensitive composition uniformly and it may become apt to produce a residue after development.

Further, in order to attain an optimal resist shape, the photo acid generator may be used in combination of two or more kinds thereof, and the photo base generator may also be used similarly.
In the present invention, an appropriate solvent can be added in addition to the above silicon-containing polymer (A1), the above silicon-containing polymer (A2) optionally added, and the above compound (B). By adding the solvent, it is possible to provide easily a photosensitive composition which can be easily applied. A solvent to be used is not particularly limited as long as it can dissolve the above-mentioned silicon-containing polymers (A), and examples of the solvent include aromatic hydrocarbon compounds such as benzene, xylene, toluene, ethylbenzene, styrene, trimethylbenzene and diethylbenzene; saturated or unsaturated hydrocarbon compounds such as cyclohexane, cyclohexene, dipentene, n-pentane, isopentane, n-hexane, isohexane, n-heptane, isoheptane, n-octane, isooctane, n-nonane, isononane, n-decane, isodecane, tetrahydronaphthalene and squalane; ethers such as diethyl ether, di-n-propyl ether, di-isopropyl ether, dibutyl ether, ethyl propyl ether, diphenyl ether, diethylene glycol dimethyl ether, diethylene glycol dimethyl ether, diethylene glycol dibutyl ether, diethylene glycol methyl ethyl ether, dipropylene glycol dimethyl ether, dipropylene glycol diethyl ether, dipropylene glycol dibutyl ether, dipropylene glycol methyl ethyl ether, ethylene glycol dimethyl ether, ethylene glycol diethyl ether, ethylene glycol dipropyl ether, ethylene glycol methyl ethyl ether, tetrahydrofuran, 1,4-dioxane, propylene glycol monomethyl ether acetate, ethylene glycol monoethyl ether acetate, dipropylene glycol methyl ether acetate, diethylene glycol monoethyl ether acetate, ethylcyclohexane, methylcyclohexane, p-menthane, o-menthane, m-menthane, dipropyl ether and dibutyl ether; ketones such as acetone, methyl ethyl ketone, methyl isobutyl ketone, diethyl ketone, dipropyl ketone, methyl amyl ketone, cyclopentanone, cyclohexanone and cycloheptanone; and esters such as ethyl acetate, methyl acetate, butyl acetate, propyl acetate, cyclohexyl acetate, methyl cellosolve acetate, ethyl cellosolve acetate, butyl cellosolve acetate, ethyl lactate, propyl lactate, butyl lactate, isoamyl lactate and butyl stearate. These solvents may be used alone or in combination of two or more kinds thereof

An amount of the above solvent to be used may be appropriately selected in such a way that the photosensitive composition can be uniformly applied when applying the photosensitive composition onto a substrate to form a photosensitive composition layer. The concentration of the photosensitive composition is preferably 0.5 to 60% by weight, more preferably about 2 to 40% by weight in terms of a solid concentration.
To the photosensitive composition of the present invention, other additives may be further added as required. Examples of such additives include a filler, a pigment, a dye, a leveling agent, an antifoaming agent, an antistatic agent, an ultraviolet absorber, a pH control agent, a dispersant, a dispersion aid, a surface modifier, a plasticizer, a plasticizing accelerator, and an anti-sagging agent.

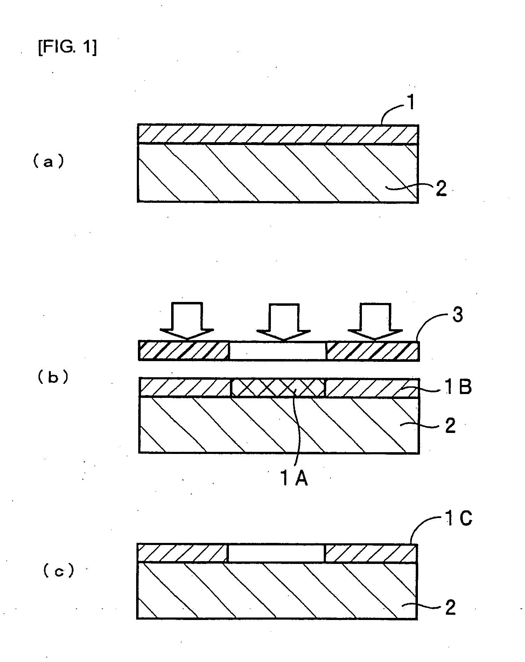

A method of producing a thin film pattern of the present invention comprises the steps of forming a photosensitive composition layer 1 consisting of the photosensitive composition of the present invention as shown, for example, in Fig. 1A, exposing selectively the photosensitive composition layer 1 with a photo mask 3 corresponding to a pattern to be formed to form a latent image 1A in the form of the pattern (Fig.1B), and developing with an alkaline aqueous solution a photosensitive layer 1B on which the latent image is formed (Fig.1C). Herein, the term "development" includes various operations of treating the photosensitive layer 1B with the alkaline aqueous solution such as the operation of immersing the photosensitive layer 1B, on which the latent image is formed, in the alkaline aqueous solution, the operation of washing down the surface of the photosensitive layer 1B with the alkaline aqueous solution, or the operation of spraying the alkaline aqueous solution onto the surface of the above photosensitive layer 1B. Further, as the developer, not only the alkaline aqueous solution, but also an acid aqueous solution or various solvents may be used.
Examples of the solvent include various solvents described above. Examples of the acid aqueous solution include oxalic acid, formic acid, acetic acid and the like.

The step of forming the above-mentioned photosensitive composition layer 1 is not particularly limited and includes, for example, a method of imparting the photosensitive composition of the present invention onto a substrate 2 shown in Fig. 1 to form a photosensitive composition layer 1. As a specific method in this case, common coating methods can be employed, and for example, dip coating, roller coating, bar coating, brushing coating, spray coating, spin coating, extrusion coating, and gravure coating can be used. As a substrate to be coated with the photosensitive composition, a silicon substrate, a glass substrate, a metal plate, or a plastic plate is used as usage. A thickness of the photosensitive composition layer varies with usage, but measure of the thickness is 10 nm to 10µm. When using a solvent for dissolving a photosensitive resin, the photosensitive composition layer coated on a substrate is desirably subjected to heat treatment in order to dry the solvent. A heat treatment temperature is generally 40 to 200°C and appropriately selected in accordance with a boiling point or a vapor pressure of the solvent.

The photosensitive composition layer is formed on the substrate and subjected to heat treatment as required, and then the photosensitive composition layer is covered with a photo mask and light is irradiated to this composition layer in the form of pattern. Thereby, a latent image in the form of required pattern can be formed. As the photomask, commercially available common photo masks may be used.

As a light source, an ultra high-voltage mercury lamp, a deep UV lamp, a high-voltage mercury lamp, a low-voltage mercury lamp, a metal halide lamp, an excimer laser and the like can be used. These light sources are appropriately selected in accordance with photosensitive wavelengths of the photo acid generator, the photo base generator and the sensitizer. As irradiation energy of light, but depending on desired thickness of the thin film or the kind of the photo acid generator, the photo base generator and the sensitizer, energy of 10 to 1000 mJ/cm² is generally used. When the energy is less than 10 mJ/cm², the silicon-containing polymer is not adequately exposed. When it is more than 1000 mJ/cm², an exposure time may become large and production efficiency per hour of the thin film pattern may be deteriorated.

In an exposed area of a photosensitive composition layer, which is irradiated in a pattern shape with light, as described above, a -SiH group of the silicon-containing polymer (A1) reacts with a water content in air and reacts with a -SiH group of an adjacent polymer by the action of an acid or a base produced from the compound (B) by exposure. As a result of this, a Si-O-Si bond is produced and crosslinking proceeds. Therefore, the exposed area becomes insoluble in a developer as a result of proceeding of crosslinking. By developing the photosensitive composition layer after exposure with a developer, an unexposed area of the photosensitive composition layer is dissolved in the developer to be removed, and the exposed area remains on a substrate. As a result of this, a pattern is formed.
This pattern is referred to as a negative pattern because the unexposed area is removed.

As the developer, an alkaline aqueous solution is preferably used because it does not require explosion-proof facilities and the burdens on facilities due to corrosion or the like are less. Examples of the developer include alkaline aqueous solutions such as an aqueous solution of tetramethylammonium hydroxide, an aqueous solution of sodium silicate, and an aqueous solution of sodium hydroxide, an aqueous solution of potassium hydroxide. The time required to develop, depending on a thickness of the photosensitive composition layer or a kind of a solvent, is generally 10 seconds to 5 minutes. It is preferred that the thin film pattern used is cleaned with distilled water after development to remove the alkaline aqueous solution remaining on the thin film. The thin film pattern thus obtained is a thin film having insulation properties. More preferably, this thin film pattern is heated at a temperature of 100 to 400°C for 5 minutes to 2 hours to increase a crosslinking density and make the filmclosely packed. Indoingso, the insulation properties and film strength are further enhanced.

Further, the photosensitive composition of the present invention is suitably used for forming a thin filmpattern in various devices, but preferably, the above-mentioned thin film pattern is effectively used for protective films of electronic devices. By using the thin film pattern, formed by using the photosensitive composition of the present invention, as an insulating protective film of an electronic device, the shape stability of the insulating protective film to be obtained can be effectively enhanced. Examples of such an insulating protective film of an electronic device include a thin film transistor (TFT) protective film or a passivation film for protecting a TFT, a protective film or an overcoat film to protect a filter in a color filter, and a protective film of an organic EL device, that is, a passivation film.

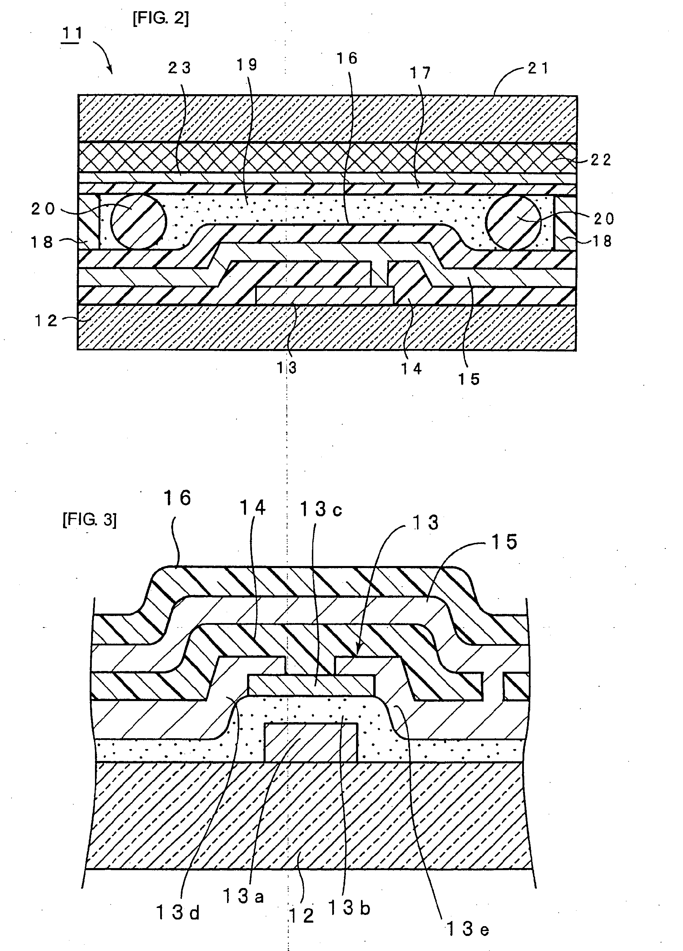

Fig.2 is a simplified diagram of a front sectional view of a liquid crystal display device in which an insulating protective film for electronic devices of the present invention is employed, and Fig.3 is a partially broken front sectional view for illustrating enlarged elemental portions of the liquid crystal display device shown in Fig.2. As shown in Fig.2, a liquid crystal display device 11 has a structure in which a TFT 13 is formed on a glass substrate 12. A TFT protective film 14 is formed so as to cover the TFT 13. In the liquid crystal display device 11, the TFT protective film 14 is constructed from the insulating protective film for electronic devices of the present invention.

The TFT protective film 14 is patterned so as to cover the TFT 13 and further so as to have a desired planar shape in the liquid crystal display device 11, and it has excellent stability of this pattern shape.
In Fig. 2, an ITO electrode 15 is formed on the TFT protective film 14. Further, an alignment layer 16 is formed so as to cover the ITO electrode 15, and the alignment layer 16 is opposite to another alignment layer 17 positioned at an upper position. A space between the alignment layers 16 and 17 is sealed with a sealing material 18, and liquid crystal 19 is filled into the inside of the sealed space. Further, in order to secure a thickness of the space, spacers 20 are located between the alignment layers 16 and 17.

The alignment layer 17 is supported by an upper glass substrate 21. That is, a color filter 22 and an ITO electrode 23 are formed on the bottom surface of the glass substrate 21, and the alignment layer 17 is formed so as to cover the ITO electrode 23.
Further, as shown under magnification in Fig.3, in a portion where the TFT 13 is formed, more specifically a gate electrode 13a is formed on a glass substrate 1.2, and a gate insulating film 13b is formed so as to cover the gate electrode 13a. A semiconductor layer 13c is formed on the gate insulating film 13b in such a manner as to be opposite to the gate electrode 13a. Furthermore, a source electrode 13d and a drain electrode 13e are connected to the semiconductor layer 13c.

The TFT protective film 14 described above is laminated to cover the TFT 3 constructed in a manner described above.

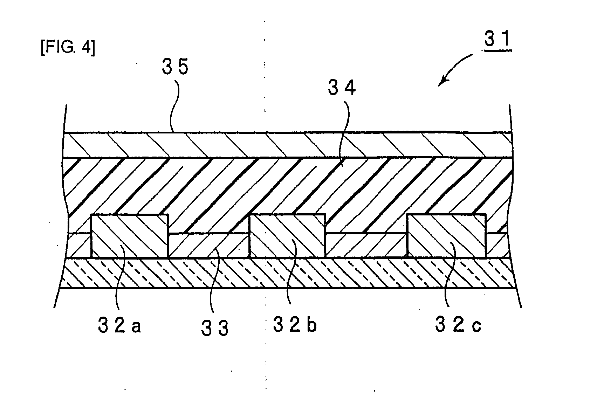

Fig.4 is a partially broken sectional view showing an example of a constitution in which an insulating protective film of the present invention is employed as a protective film in a liquid crystal display device and a color filter. Herein, a color filter 31 has a pixel 32a of red color, a pixel 32b of green color and a pixel 32c of blue color, and a black matrix portion 33. An insulating protective film 34 is formed so as to cover these pixels and the matrix portion, and the insulating protective film for electronic devices of the present invention is used as the insulating protective film 34. Therefore, the shape stability of a planar shape of the protective film 34 is effectively enhanced. In addition, an ITO electrode 35 is formed on the protective film 34.

In addition, the insulating protective film for electronic devices of the present invention is widely used not only for the liquid crystal display device or the color filter, described above, but for various insulating protective films for electronic devices such as a TFT protective film of an organic EL device, an interlayer insulation film of an IC chip, an interlayer protective film of an IC chip, and an insulating layer of a sensor. Therefore, in accordance with the present invention, it is possible to provide display devices such as the foregoing EL device and liquid crystal display device, including the above-mentioned thin film as a protective film for electronic devices, and a thin film transistor, including the color filter or above-mentioned thin film as a passivation film.
Among others, the thin film obtained by irradiating an active ray or radiation ray to the silicon-containing photosensitive composition of the present invention to introduce a crosslinked structure is suitably employed as a gate insulating film of a field-effect thin film transistor. That is, in the thin film transistor provided by the present invention, the gate insulating film is formed through a thin film pattern formed in the manner described above. In this case, as described above, an large-scale vacuum apparatus is not required for forming the gate insulating film. Therefore, the gate insulating film can be efficiently formed at low price.

In addition, since the gate insulating film is composed of a crosslinked film of the above silicon-containing photosensitive composition, it is possible to enhance the mobility and the on/off current value as is apparent from Experimental Examples described later
Further, in the thin film transistor of the present invention, preferably, a passivation film is further included and this passivation film is also composed of a crosslinked film of the above silicon-containing photosensitive composition. In this case, protective performance under high temperatures and high humidities can also be enhanced compared with a conventional passivation film consisting of a PVA film.

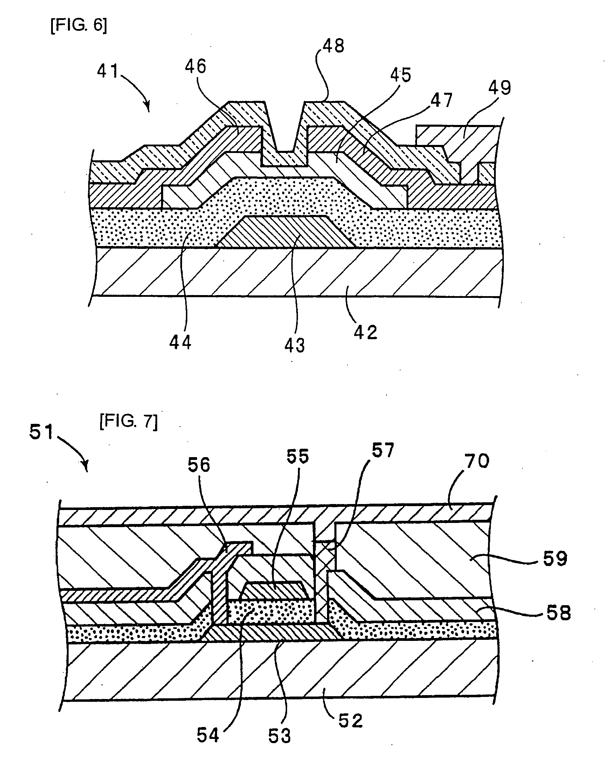

In the thin film transistor of the present invention, structures other than the gate insulating film are not particularly limited from that the gate insulating film is composed of a crosslinked film of the above specific silicon-containing photosensitive composition as described above. That is, a physical structure of the thin film transistor of the present invention is not particularly limited as long as the thin filmtransistor is a field-effect thin filmtransistor including a semiconductor layer, a source electrode and a drain electrode, which are provided so as to be in contact with the semiconductor layer, and a gate electrode, and the above-mentioned gate insulating film placed between the gate electrode and the semiconductor layer. Specific structural examples of such a field-effect thin film transistor are exemplified in Figs.6 and 7.

In a thin film transistor 41 shown in Fig. 6, a gate electrode 43 is formed on a substrate 42. A gate insulating film 44 is formed so as to cover the gate electrode 43. This gate insulating film 44 is composed of a crosslinked film of the above specific silicon-containing photosensitive composition. Further, a semiconductor layer 45 is laminated on the gate insulating film 44. A source electrode 46 and a drain electrode 47 are formed so as to be in contact with the semiconductor layer 45. Further, a passivation film 48 is formed so as to cover the semiconductor layer 45, the source electrode 46 and the drain electrode 47. An ITO electrode 49 leading to the drain electrode 47 is formed on the passivation film 48.

On the other hand, in the thin film transistor 51 shown in Fig. 7, a semiconductor layer 53 is formed on a substrate52 . A gate insulating film 54 is formed on the semiconductor layer 53. This gate insulating film 54 is formed from a crosslinked film of the above silicon-containing photosensitive composition. A gate electrode 55 is formed on the above-mentioned gate insulating film 54. On the other hand, a source electrode 56 and a drain electrode 57 pass through the above gate insulating film 54 and are joined to the semiconductor layer 53.

Further, a passivation film 58 is formed on the gate insulating film 54 and the gate electrode 55. Further, in order to flatten a top face, a passivation film 59 is laminated, and an ITO electrode 60 leading to the drain electrode 57 is formed on the passivation film 59.

As shown in the above-mentioned thin film transistors 41, 51, a structure of the thin film transistor to which the present invention is applied is not particularly limited. A material composing a semiconductor layer in the thin film transistor of the present invention is also not particularly limited and various semiconductors such as amorphous silicon, polysilicon and organic semiconductors can be employed. The source electrode, the drain electrode and the gate electrode may also be composed of electrode materials made of appropriate metals.

The passivation films 48, 58, 59 are not essential, but they are preferably composed of the crosslinked film of the above-mentioned silicon-containing photosensitive composition. However, the passivation films 48, 58, 59 may be composed of inorganic materials such as SiN or organic materials such as PVA. Further, the crosslinked film of the above silicon-containing photosensitive composition may be used in combination with inorganic materials such as SiN or organic materials such as PVA to constitute the passivation films 48, 58, 59.

The silicon-containing photosensitive composition of the present invention contains at least one silicon-containing polymer (A1) as a silicon-containing polymer, and at least one of substituent groups R₁₁ to Rₗₙ is H in the silicon-containing polymer (A1) . Since a -SiH group has high reactivity, the -SiH group reacts with H₂O (water content) in air to produce a Si-O-Si bond when the compound (B) generates an acid or a base when irradiated with an active ray or radiation ray. Therefore, crosslinking proceeds by the production of a Si-O-Si bond, and the silicon-containing photosensitive composition becomes insoluble in a developer. Therefore, in accordance with the present invention, it is possible to provide a photosensitive composition which is developable without using a crosslinking agent.

Thus, since the crosslinking agent does not have to be used, or since it is only necessary to add a minute amount of the crosslinking agent even if the crosslinking agent is used, coloring, deterioration of characteristics, or the like due to use of the crosslinking agent can be effectively inhibited.
Further, a crosslinking structure based on the production of the above Si-O-Si bond has excellent heat resistance. Therefore, in accordance with the present invention, since the obtained thin film pattern has excellent heat resistance, a thin film pattern having excellent resistance to environmental characteristics can be formed and annealing by heating is suitably performed.

Further, in the present invention, the silicon-containing polymer (A2) may be further added. When the silicon-containing polymer (A1) is produced, generally, the silicon-containing polymer (A2) is also produced. Therefore, by using a mixture containing the silicon-containing polymer (A2) in addition to the silicon-containing polymer (A1) obtained according to a normal production method, the photosensitive composition of the present invention can be easily provided.

In the thin film transistor of the present invention, the gate insulating film is composed of a crosslinked film of the above specific silicon-containing photosensitive composition. This crosslinked film is formed from an organic-inorganic hybrid material and can be easily formed without the need to use a large-scale vacuum apparatus as with a thin film consisting of an organic material, and further has a closely packed film structure. Therefore, it becomes possible not only to form the gate insulating film at low cost but also to enhance the mobility and the on/off current ratio in a thin film transistor to be obtained. Accordingly, it becomes possible to provide a high-performance thin film transistor at low price.

In the present invention, when the passivation film is composed of a crosslinked film of the above silicon-containing photosensitive composition, moisture resistance of the passivation film is enhanced and therefore it becomes possible to inhibit the deterioration of performance under high temperatures and high humidities.
Since the gate insulating film of the present invention is composed of a crosslinked film of the above silicon-containing photosensitive composition, it can form a film at low cost according to the present invention, and it becomes possible to provide a thin film transistor having excellent performance.

### BRIEF DESCRIPTION OF THE DRAWINGS

Figs. 1A to 1C are sectional views of the respective steps for illustrating a method of producing a thin film pattern of the present invention.
Fig.2 is a front sectional view showing a liquid crystal display device in which an insulating protective film for electronic devices of the present invention is employed.
Fig.3 is a partially broken front sectional view for illustrating elemental portions of the liquid crystal display device shown in Fig.2.
Fig.4 is a partially broken front sectional view showing a color filter in which an insulating protective film for electronic devices of the present invention is employed.
Fig.5 is a view showing a relationship between a weight average molecular weight of a silicon-containing polymer and a ratio (mole percentage) of substituent groups being H in substituent groups.
Fig.6 is a schematic front sectional view showing an example of a structure of a thin film transistor of the present invention.
Fig.7 is a schematic front sectional view showing an example of another structure of a thin film transistor of the present invention.

### DESCRIPTION OF SYMBOLS

- 1: photosensitive composition layer
- 1A: latent image
- 1B: photosensitive layer
- 1C: thin film pattern.
- 2: substrate
- 3: photo mask
- 11: liquid crystal display device
- 12: glass substrate
- 13: TFT
- 13a: gate electrode
- 13b: gate insulating film
- 13c: semiconductor layer
- 13d: source electrode
- 13e: drain electrode
- 14: TFT protective film (insulating protective film for electronic devices)
- 15: ITO (indium tin oxide)
- 16: alignment layer
- 17: alignment layer
- 18: sealing material
- 19: liquid crystal
- 20: spacer
- 21: glass substrate
- 22: color filter
- 23: ITO
- 31: color filter
- 32a to 32c: pixel
- 33: black matrix portion
- 34: protective film (insulating protective film for electronic devices)
- 35: ITO electrode
- 41: thin film transistor
- 42: substrate
- 43: gate electrode
- 44: gate insulating film
- 45: semiconductor layer
- 46, 47: source electrode or drain electrode
- 48: passivation film
- 49: ITO electrode
- 51: thin film transistor
- 52: substrate
- 53: semiconductor layer
- 54: gate insulating film
- 55: gate electrode
- 56, 57: source electrode or drain electrode
- 58, 59: passivation film
- 70: ITO electrode

### BEST MODE FOR CARRYING OUT THE INVENTION

Hereinafter, the present invention will be described by way of examples and comparative examples of the present invention. Further, the present invention is not limited to the following examples.

### (Experimental Example 1)

### (Preparation of polymer (A-a))

5 g of phenyltriethoxysilane, 10 g of triethoxysilane, 0. 5 g of oxalic acid, 5 ml of water, and 50 ml of propylene glycol monomethyl ether acetate were added to a 100 mL flask equipped with a cooling tube to obtain a solution. The resulting solution was stirred with a semicircular type mechanical stirrer, heated to 70°C with a mantle heater, and reacted at this temperature for 6 hours. Then, water and ethanol produced by a condensation reaction were removed by an evaporator. After the completion of the reaction, the flask was left standing until a temperature of the flask became room temperature to prepare a mixture including silicon-containing polymers. Materials and amounts used in Experimental Example 1, and a ratio (mole%) of substituent groups which are H are shown in Table 1 below. Incidentally, the term "a ratio (mole%) of substituent groups which are H" means a ratio of substituent groups being H in substituent groups R₁₁ to R₁ₙ with respect to 100 mole% of the total of substituent groups R₁₁ to R₁ₙ and substituent groups R₂₁ to R₂ₙ in the general formulas (1) and (2).

### (Preparation of polymers (A-b) to (A-e))

Polymers (A-b) to (A-e) were prepared by following the same procedure as in the above-mentioned preparation of polymer (A-a) except for changing the kinds or the amounts to be used of phenyltriethoxysilane, triethoxysilane, oxalic acid and formic acid as shown in the following Table 1.

### (Example 1)

100 parts by weight of the above-mentioned mixture of silicon-containing polymers and 5 parts by weight of a sulfonium salt-based photo acid generator (Naphtalimide camphorsulfonate (CAS No. 83697-56-7), produced by Midori Kagaku Co., Ltd., trade name: NAI-106) as a compound (B) were dissolved in 500 parts by weight of tetrahydrofuran as a solvent to prepare a photosensitive composition.

This photosensitive composition was spin-coated at a rotational speed of 1000 rpm on a silicon wafer of 0.75 mm in thickness. After application of the photosensitive composition, the photosensitive composition was dried in a hot air oven of 80°C to form a coat with a film thickness of 0.5 µm. Next, using an ultraviolet irradiation apparatus (manufactured by USHIO INC., SPOT-CURE SP-5), ultraviolet light with a wavelength of 365 nm was irradiated to this coat through a photo mask having a predetermined pattern for 5 seconds at UV illumination of 100 mW/cm² so that irradiation energy becomes 500 mJ/cm². After the irradiation of UV, the coat was heated for 5 minutes in the hot air oven of 80°C. Thereafter, the coat was immersed for 2 minutes in a 2.38% aqueous solution of tetramethylammonium hydroxide.
Consequently, a coat in a portion to which ultraviolet light was not irradiated was dissolved to form a pattern with L/S (line and space) of 10 µm, derived from the photo mask.

### (Examples 2, 3, 4 and Comparative Examples 1, 2)

The formation of thin film patterns was tried by following the same procedure as in Example 1 except for changing the composition of polymers as shown in Table 2 below.

**[Table 1]**

| Polymer | Triethoxysilane | Phenyltriethoxysilane | Oxalic Acid | Formic Acid | Water | Propylene Glycol Monoethyl Ether Acetate | Ratio of Substituent Groups being H (mole%) |
|---|---|---|---|---|---|---|---|
| A-a | 10g | 5g | 0.5g | | 5ml | 50ml | 75 |
| A-b | 1. 6g | 13. 4g | 0.5g | | 5ml | 50ml | 15 |
| A-c | 1g | 14g | 0.5g | | 5ml | 50ml | 9 |
| A-d | | 15g | 0.5g | | 5ml | 50ml | 0 |
| A-e | 5g | 10g | | 0. 5g | 5ml | 50ml | 42 |

**[Table 2]**

| | Ex.1 | Ex. 2 | Ex. 3 | Ex. 4 | Comp. Ex. 1 | Comp. Ex. 2 |
|---|---|---|---|---|---|---|
| Polymer A- a | 100 | | | | | |
| Polymer A- b | | 100 | 100 | | | |
| Polymer A- c | | | | | 100 | |
| Polymer A- d | | | | | | 100 |
| Polymer A- e | | | | 100 | | |
| NAI-106 | 5 | 5 | | 5 | 5 | 5 |
| Amine Imide Compound | | | 5 | | | |
| Tetrahydrofuran | 500 | 500 | 500 | 500 | 500 | 500 |

| | | | | | | |
|---|---|---|---|---|---|---|
| (Unit: Parts by Weight) | | | | | | |

An amine imide compound was prepared by adding p-nitrobenzoic acid methyl ester, N,N-dimethylhydrazine and phenyl glycidyl ether to tert-butanol.

### (Evaluation of Examples and Comparative Examples)

Solubility in alkali in forming the above-mentioned thin film patterns was evaluated also in Examples 2 to 4 and Comparative Examples 1 and 2 in the same manner as in Example 1. The results of evaluations are shown together in Table 3.

**[Table 3]**

| Test Items | Ex.1 | Ex.2 | Ex.3 | Ex. 4 | Comp. Ex. 1 | Comp. Ex. 2 |
|---|---|---|---|---|---|---|
| Formation of Pattern | ○ | ○ | ○ | ○ | × | × |

### (Experimental Example 2)

Various silicon-containing polymers A-a to A-aa were prepared by following the same procedure as in Example 1 as described in Table 4 below. That is, the silicon-containing polymers A-a to A-e were prepared by following the same procedure as in Example 1. Further, the silicon-containing polymers A-f to A-aa were prepared by following the same procedure as in Example 1 except for changing the monomers and materials used. Further, in Table 4, the concentration (% by weight) of monomer components in a solution consisting of monomer components, oxalic acid or formic acid, water, and propylene glycol monoethyl ether acetate as a solvent, and a polymerization temperature and a polymerization time as polymerization conditions are shown together. Further, the weight average molecular weight Mw of the obtained silicon-containing polymer and the ratio of substituent groups being H in each silicon-containing polymer are shown in Table 4.
Silicon-containing photosensitive compositions were prepared by following the same procedure as in Example 1 using any one of the silicon-containing polymers A-f to A-aa obtained as described above.

**[Table 4]**

| Polymer | Triethoxysilane | Phenytriethoxysilane | Oxalic Acid | Formic Acid | Water | Propylene Glycol Monoethyl Ether Acetate | Ratio of Substituent Groups being H (mole%) | Concentration at Polymerization (%) | Polymerization Temperature and Time | Weight Average Molecular Weight (Mw) |
|---|---|---|---|---|---|---|---|---|---|---|
| A-a | 10g | 5g | 0. 5g | | 5ml | 50ml | 75 | 29 | 70°C·6hr | 4,000 |
| A-b | 1. 6g | 13.4g | 0. 5g | | 5ml | 50ml | 15 | 29 | 70°C·6hr | 4,000 |
| A-c | 1g | 14g | 0. 5g | | 5ml | 50ml | 9 | 29 | 70°C·6hr | 4,000 |
| A-d | | 15g | 0. 5g | | 5ml | 50ml | 0 | 29 | 70°C·6hr | 4,000 |
| A-e | 5g | 10g | | 0. 5g | 5ml | 50ml | 42 | 29 | 70°C·6hr | 4,000 |
| A-f | 15g | | 0. 5g | | 5ml | 50ml | 100 | 29 | 70°C·6hr | 4,000 |
| A-g | 6g | 9g | 0. 5g | | 5ml | 22.5ml | 50 | 40 | 70°C·6hr | 7,000 |
| A-h | 15g | | 0. 5g | | 5ml | 22.5ml | 100 | 40 | 70°C·6hr | 7,000 |
| A-i | 10g | 5g | 0.5g | | 5ml | 15ml | 75 | 50 | 70°C·6hr | 10,000 |
| A-j | 15g | | 0. 5g | | 5ml | 15ml | 100 | 50 | 70°C·6hr | 10,000 |
| A-k | 0. 2g | 14.8g | 0. 5g | | 5ml | 50ml | 2 | 29 | 60°C·6hr | 3,000 |
| A- l | 0.01g | 14. 99g | 0. 5g | | 5ml | 50ml | 0. 1 | 29 | 60°C·6hr | 3,000 |
| A-m | | 15g | 0. 5g | | 5ml | 50ml | 0 | 29 | 60°C·6hr | 3.000 |
| A-n | 15g | | 0. 5g | | 5ml | 50ml | 100 | 29 | 50°C·6hr | 2,300 |
| A-o | 10g | 5g | 0.5g | | 5ml | 50ml | 75 | 29 | 50°C·6hr | 2,300 |
| A-p | 0.01g | 14.99g | 0. 5g | | 5ml | 50ml | 0.1 | 29 | 50°C·6hr | 2,300 |
| A-q | | 15g | 0. 5g | | 5ml | 50ml | 0 | 29 | 50°C·6hr | 2,300 |
| A-r | 6g | 9g | 0. 5g | | 5ml | 50ml | 50 | 29 | 30°C·6hr | 1,000 |
| A-s | 2.2g | 12. 8g | 0.5g | | 5ml | 50ml | 20 | 29 | 30°C·6hr | 1,000 |
| A-t | 1.1g | 13.9g | 0. 5g | | 5ml | 50ml | 10 | 29 | 30°C·6hr | 1,000 |
| A-u | 0.5g | 14.5g | 0.5g | | 5ml | 50ml | 5 | 29 | 30°C·6hr | 1,000 |
| A - v | 0.01g | 14. 99g | 0. 5g | | 5ml | 50ml | 0.1 | 29 | 30°C·6hr | 1,000 |
| A-w | | 15g | 0.5g | | 5ml | 50ml | 0 | 29 | 30°C·6hr | 1,000 |
| A-x | 15g | | 0. 5g | | 5ml | 135ml | 100 | 10 | 30°C·6hr | 300 |
| A-y | 6g | 9g | 0. 5g | | 5ml | 135ml | 50 | 10 | 30°C·6hr | 300 |
| A-z | 0.01g | 14. 99g | 0.5g | | 5ml | 135ml | 0.1 | 10 | 30°C·6hr | 300 |
| A-aa | | 15g | 0. 5g | | 5ml | 135ml | 0 | 10 | 30°C·6hr | 300 |

Each coat was formed on a wafer by following the same procedure as in Example 1 using the silicon-containing photosensitive compositions prepared as described above. Thereafter, the coat was immersed for 2 minutes in a 2.38 wt% aqueous solution of tetramethylammonium hydroxide as with Example 1 to evaluate the surviving property of the coat. Further, furthermore, the coat was immersed for 2 minutes in a 2.38 % aqueous solution of tetramethylammonium hydroxide one week after forming a coat by following the same procedure as described above using the silicon-containing photosensitive compositions to evaluate the surviving property of the coat.
The results are shown in Fig.5.

A lateral axis of Fig. 5 indicates the weight average molecular weight Mw of the above-mentioned silicon-containing polymer. When two or more kinds of silicon-containing polymers are used, a weight average molecular weight of a mixture of two or more kinds of silicon-containing polymers corresponds to Mw in Fig.5.
Further, a vertical axis of Fig.5 indicates the ratio (mole%) of substituent groups being H in the substituent groups, but the vertical axis is represented in a log scale. Further, in Fig.5, the case where the ratio of substituent groups being H is zero is schematically shown below the case where the ratio of substituent groups being H is 0.1 mole%.

In Fig. 5, a symbol ⊙ shows that the coat was dissolved in a portion to which ultraviolet light was not irradiated in both cases of immersing immediately and one week after forming the coat to form precisely the pattern derived from a photo mask. That is, this symbol shows that a developing property was good. On one hand, a symbol ▲ shows that a developing property was good in the case of immersing immediately after forming the coat but the developing property was not good in the case of immersing one week after forming the coat.
On the other hand, a symbol x in Fig. 5 shows that in both cases of immersing immediately and one week after forming the coat, developing was not well performed, for example, the coat was peeled off or the coat was dissolved even in a portion to which ultraviolet light was irradiated.

As is apparent from Fig.5, it is evident that if a silicon-containing polymer falls within an area enclosed by a broken line A, a developing property is good and the coat was hardly peeled off from a silicon wafer in both cases of immersing immediately and one week after forming the coat.
Next, examples of a thin film transistor will be described.
A thin film transistor 41 shown in Fig.6 was fabricated. A gate electrode 43 made of N type-doped silicon was formed on a silicon substrate. Thereafter, a gate insulating film and others were fabricated in manner of the following descriptions.

### (Example 5)

### (Preparation of polymer)

5 g of phenyltriethoxysilane, 10 g of triethoxysilane, 0.5 g of oxalic acid, 5 ml of water, and 50 ml of propylene glycol monomethyl ether acetate were added to a 100 mL flask equipped with a cooling tube to obtain a solution. The resulting solution was stirred with a semicircular type mechanical stirrer, heated to 70°C with a mantle heater, and reacted at this temperature for 6 hours. Then, water and ethanol produced by a condensation reaction were removed by an evaporator. After the completion of the reaction, the flask was left standing until a temperature of the flask became room temperature to prepare a mixture of silicon-containing polymers.

100 parts by weight of the above-mentioned mixture of silicon-containing polymers and 5 parts by weight of a sulfonium salt-based photo acid generator (Naphtalimide camphorsulfonate (CAS No. 83697-56-7), produced by Midori Kagaku Co., Ltd., trade name: NAI-106) as a compound (B) were dissolved in 1000 parts by weight of tetrahydrofuran as a solvent to prepare a photosensitive composition.

For a gate insulating film, this photosensitive composition was spin-coated at a rotational speed of 1500 rpm. After application of the photosensitive composition, the photosensitive composition was dried in a hot air oven of 80°C to form a coat with a film thickness of 200 nm. Next, ultraviolet light with a wavelength of 365 nm was irradiated to this coat through a photo mask having a predetermined pattern for 3 seconds at UV illumination of 100 mW/cm² so that irradiation energy becomes 300 mJ/cm². After the irradiation of UV, the coat was heated for 2 minutes in the hot air oven of 80°C. Thereafter, the coat was developed in a 2.38% aqueous solution of tetramethylammonium hydroxide to perform patterning, and then the coat was heated at 150°C for 1 hour to obtain a gate insulating film.

After forming the above-mentioned gate insulating film, a source electrode and a drain electrode, made of Au (gold), were prepared by vapor deposition. Next, an organic semiconductor layer made of pentacene was formed. In the formation of the organic semiconductor layer, pentacene was deposited on the above-mentioned gate insulating film by sublimation of the pentacene under the output of 1×10⁻⁵ torr to form a semiconductor layer with a film thickness of 100 nm.
Thereby, a thin film transistor of Example 5 having a channel length of 100 µm and a channel width of 10 µm was fabricated.

### (Comparative Example 3)

A thin film transistor was obtained by following the same procedure as in Example 5 except for forming a SiO₂ film so as to be 200 nm in thickness as a gate insulating film by thermal oxidation.

### (Comparative Example 4)

A thin film transistor was obtained by following the same procedure as in Example 5 except for forming a gate insulating film by forming a PVA film in the way described below
As for the formation of the PVA film, a polyvinyl alcohol solution ((2 wt% solution (solvent: composed of water and methanol in proportions of 4:1) of polyvinyl alcohol (N-300 produced by Nippon Synthetic Chemical Industry Co., Ltd.)) was applied onto a silicon substrate by a spin coating process (2000 rpm) and cured by heating at 110°C to form a polyvinyl alcohol film with a thickness of 200 nm as a gate insulating film.

### (Comparative Example 5)

A passivation film with a thickness of 500 nm was formed by forming a film of a 4 wt% solution of the same polyvinyl alcohol as in Comparative Example 4 on the uppermost portion of the thin film transistor obtained in Comparative Example 3 by a spin coating process (2000 rpm) and heating the film.

### (Example 6)

A source electrode and a drain electrode were prepared by following the same procedure as in Example 5, and then a passivation film with a thickness of 500 nmwas formed by following the same procedure as that of the step of forming a gate insulating film of Example 5 except for changing the amount of tetrahydrofuran to be added as a solvent to 500 parts by weight and the rotational speed of spin-coating to 1000 rpm. Thereby, a thin film transistor, on which a passivation film was laminated, was obtained.

### (Example 7)

A passivation film with a thickness of 500 nm was formed by forming a film of a 4 wt% solution of the same polyvinyl alcohol as in Comparative Example 4 on the uppermost portion of the thin film transistor obtained in Example 5 by a spin coating process (2000 rpm) and heating the film.

### (Example 8)

A thin film transistor was obtained by following the same procedure as in Example 6 except for forming SiO₂ so as to be 200 nm in thickness as a gate insulating film by thermal oxidation.

### (Evaluation)

### 1. Initial characteristic

An on/off current ratio I_{ON}/ I_{OFF} and mobility µ were measured as initial characteristics. The results of measurements are shown in Table 5 below.

### 2. High-temperature acceleration test

A direct-current voltage of 15 V was applied between a gate electrode and a source electrode at a temperature of 80°C for 240 hours to perform a high-temperature acceleration test. On/off current ratios and mobility after this high-temperature acceleration test were evaluated in Examples 6 and 7.
The results of evaluations are shown in Table 5 below.

**[Table 5]**

| | | Ex. 5 | Ex. 6 | Ex. 7 | Ex. 8 | Comp. Ex. 3 | Comp.Ex.4 | Comp.Ex.5 |
|---|---|---|---|---|---|---|---|---|
| | Gate | Si | Si | Si | Si | Si | Si | Si |
| | S, D | Au | Au | Au | Au | Au | Au | Au |
| | Gate Insulating Film | Silicon-Containing Photosensitive Crosslinked Film | Silicon-Containing Photosensitive Crosslinked Film | Silicon-Containing Photosensitive Crosslinked Film | SiO₂ | SiO₂ | PVA | SiO₂ |
| | Organic Semiconductor | Pentacene | Pentacene | Pentacene | Pentacene | Pentacene | Pentacene | Pentacene |
| | Passivation | - | Silicon-Containing Photosensitive Crosslinked Film | PVA | Siticon-Containing Photosensitive Crosslinked Film | - | - | PVA |
| Initial | I_{ON}/I_{OFF} | 10⁶ | 10⁶ | 10⁶, | 10⁶ | 10⁶ | 10⁵ | 10⁶ |
| | µ (cm²/ V_{S}) | 0.78 | 0.89 | 0. 91 | 0. 90 | 0.82 | 0.65 | 0.85 |
| Energization at 80°C for 240 hours | I_{ON}/I_{OFF} | - | 10⁶ | 10⁵ | 10⁶ | - | - | 10⁵ |
| | µ (cm²/ Vₛ) | - | 0. 85 | 0. 78 | 0. 86 | - | - | 0.76 |

As is apparent from Table 5, in Comparative Example 3, the on/off current ratio was as high as 10⁶ and the mobility was also as high as 0. 82 since the gate insulating film was composed of a closely packed SiO₂ film. On the other hand, in Comparative Example 4, the on/off current ratio was as low as 10⁵ and the mobility was also as low as 0. 65 (cm²/ Vs) since the gate insulating film consists of a PVA film.

For this, in Examples 5 to 7, it is evident that all of the on/off current ratios were as high as 10⁶ since each insulating film is composed of a crosslinked film of the above silicon-containing photosensitive composition and the mobility was equal to Comparative Example 3 in an initial condition.
On the other hand, in Comparative Example 3, since the gate insulating film is formed by forming a film of SiO₂ by a CVD method as described above, this case requires an expensive vacuum apparatus and much time for producing the gate insulating film, and production cost is also high. Contrarily, in Examples 5 to 7, it was possible to reduce the production cost of the gate insulating film and simplify the process step since the gate insulating film can be easily formed by only applying the silicon-containing photosensitive solution and irradiating light as described above.

Further, as is apparent from a comparison between Example 6 and Example 7 and a comparison between Example 8 and Comparative Example 5, it is evident that when the passivation film is composed of the silicon-containing photosensitive solution of the present invention, the on/off current ratios were as high as 10⁶ and the mobility µ was equal to the initial condition even after high-temperature energization acceleration test..

## Claims

1. A silicon-containing photosensitive composition, **characterized by** containing at least one silicon-containing polymer (A1) having a structure represented by the following general formula (1): 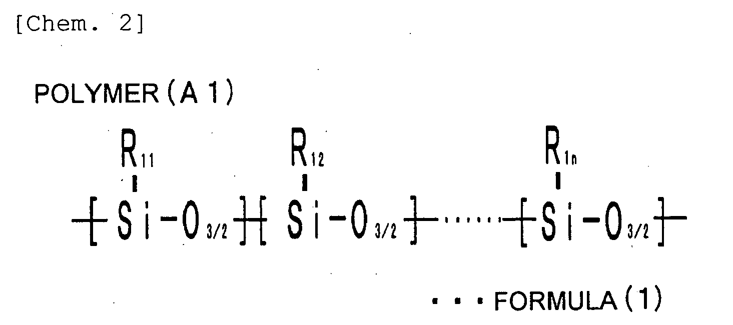 wherein at least one of R₁₁ to R₁ₙ represents H, and n represents an integer of 1 or more, and
a compound (B) which generates an acid or a base when irradiated with an active ray or radiation ray.

2. The silicon-containing photosensitive composition according to claim 1, wherein when a weight average molecular weight of said silicon-containing polymer (A1) is denoted by Mw and the total of substituent groups R₁₁ to R₁ₙ in said silicon-containing polymer (A1) is regarded as 100 mole%, a ratio of substituent groups being H is adapted to fall within an area enclosed by a broken line A in Fig. 5, which varies with the weight average molecular weight Mw.

3. The silicon-containing photosensitive composition according to claim 1, **characterized by** further containing at least one polymer (A2) represented by the following general formula (2): 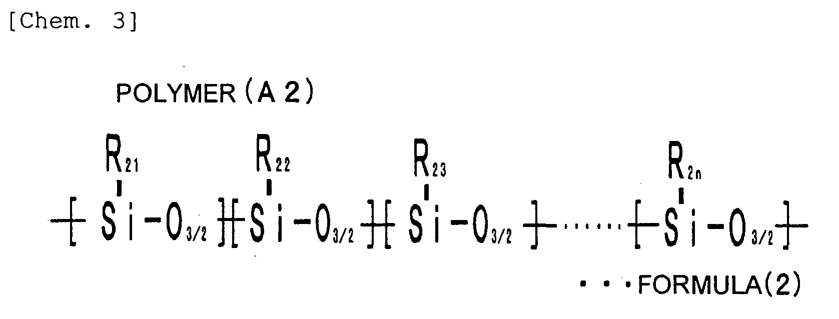 wherein each of groups R₂₁ to R₂ₙ represents an atom other than H or a functional group, and n represents an integer of 1 or more.

4. The silicon-containing photosensitive composition according to claim 3, wherein when a weight average molecular weight of said silicon-containing polymer (A1) and said silicon-containing polymer (A2) is denoted by Mw and the total of substituent groups R₁₁ to R₁ₙ and substituent groups R₂₁ to R₂ₙ in said silicon-containing polymer (A1) and said silicon-containing polymer (A2) is regarded as 100 mole%, a ratio of substituent groups being H is adapted to fall within an area enclosed by a broken line A in Fig. 5, which varies with the weight average molecular weight Mw.

5. The silicon-containing photosensitive composition according to any one of claims 1 to 4, wherein said compound (B) is at least one compound selected from the group consisting of an onium salt, a diazonium salt, and a sulfonic acid ester.

6. The silicon-containing photosensitive composition according to any one of claims 1 to 5, wherein said compound (B) is an amine imide compound which generates a base when irradiated with an active ray or radiation ray.

7. A method of producing a thin film pattern, comprising the steps of
forming a photosensitive composition layer consisting of the silicon-containing photosensitive composition according to any one of claims 1 to 6 on a substrate,
exposing selectively with an active ray or radiation ray in accordance with a pattern formed on said photosensitive composition layer to form a latent image in the form of pattern, and
developing said photosensitive composition layer on which said latent image is formed with a developer to obtain a thin film pattern.

8. A protective film for electronic devices formed by using the silicon-containing photosensitive composition according to any one of claims 1 to 6.

9. A transistor, **characterized by** including a thin film formed by using the silicon-containing photosensitive composition according to any one of claims 1 to 6 as a protective film.

10. A color filter, **characterized by** including a thin film formed by using the silicon-containing photosensitive composition according to any one of claims 1 to 6 as a protective film.

11. An organic EL device, **characterized by** including a thin film formed by using the silicon-containing photosensitive composition according to any one of claims 1 to 6 as a protective film.

12. A gate insulating film of a field-effect transistor, **characterized by** consisting of a thin film formed by using the silicon-containing photosensitive composition according to any one of claims 1 to 6.

13. A field-effect thin film transistor including a semiconductor layer, a source electrode and a drain electrode, which are provided so as to be in contact with the semiconductor layer, a gate electrode, anda gate insulating filmplaced between the gate electrode and the semiconductor layer, **characterized in that** said gate insulating film is composed of a thin film formed by using the silicon-containing photosensitive composition according to any one of claims 1 to 6.

14. A field-effect thin film transistor including a semiconductor layer, a source electrode and a drain electrode, which are provided so as to be in contact with the semiconductor layer, a gate electrode, a gate insulating film placed between the gate electrode and the semiconductor layer, and a passivation film, **characterized in that** said passivation film is a thin film formed by using the silicon-containing photosensitive composition according to any one of claims 1 to 6.

## Amended claims

### Amended claims under Art. 19.1 PCT

**1.** (Amended) A silicon-containing photosensitive composition, **characterized in that** said silicon-containing photosensitive composition contains at least one silicon-containing polymer (A1) having a structure represented by the following general formula (1): 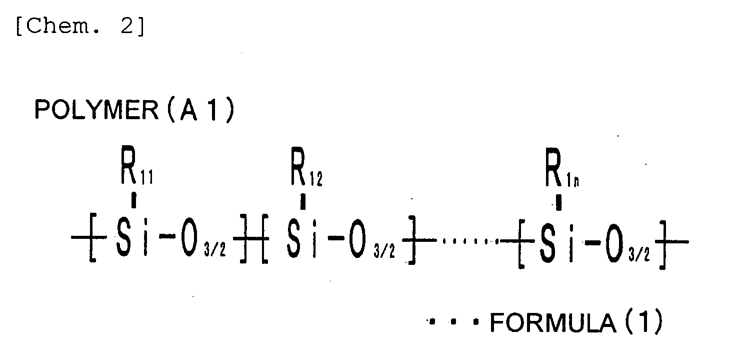 wherein at least one of R₁₁ to R₁ₙ represents H, and n represents an integer of 1 or more, and
a compound (B) which generates an acid or a base when irradiated with an active ray or radiation ray, and
when a weight average molecular weight of said silicon-containing polymer (A1) is denoted by Mw and the total of substituent groups R₁₁ to R₁ₙ in said silicon-containing polymer (A1) is regarded as 100 mole%, a ratio of substituent groups being H is adapted to fall within an area enclosed by a broken line A in Fig.5, depending on the weight average molecular weight Mw.

**2.** (Deleted)

**3.** (Amended) A silicon-containing photosensitive composition, **characterized by** containing at least one silicon-containing polymer (A1) having a structure represented by the following general formula (1): 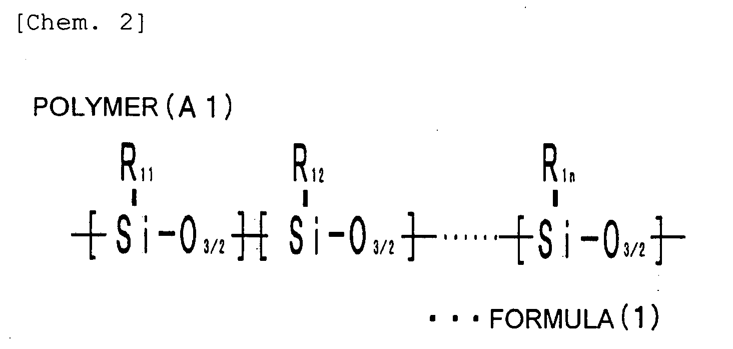 wherein at least one of R₁₁ to R₁ₙ represents H, and n represents an integer of 1 or more, and
a compound (B) which generates an acid or a base when irradiated with an active ray or radiation ray, and further containing at least one polymer (A2) represented by the following general formula (2): 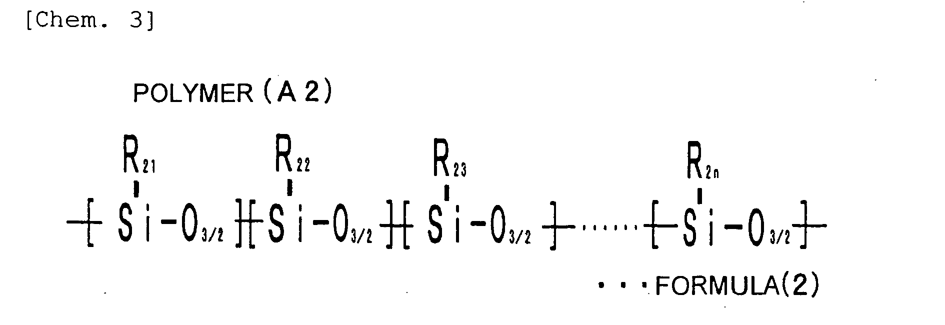 wherein each of groups R₂₁ to R₂ₙ represents an atom other than H or a functional group, and n represents an integer of 1 or more.

**4.** The silicon-containing photosensitive composition according to claim 3, wherein when a weight average molecular weight of said silicon-containing polymer (A1) and said silicon-containing polymer (A2) is denoted by Mw and the total of substituent groups R₁₁ to R₁ₙ and substituent groups R₂₁ to R₂ₙ in said silicon-containing polymer (A1) and said silicon-containing polymer (A2) is regarded as 100 mole%, a ratio of substituent groups being H is adapted to fall within an area enclosed by a broken line A in Fig.5, depending on the weight average molecular weight Mw.

**5.** (Amended) The silicon-containing photosensitive composition according to any one of claims 1, 3 and 4, wherein said compound (B) is at least one compound selected from the group consisting of an onium salt, a diazonium salt, and a sulfonic acid ester.

**6.** (Amended) The silicon-containing photosensitive composition according to any one of claims 1, 3, 4 and 5, wherein said compound (B) is an amine imide compound which generates a base when irradiated with an active ray or radiation ray.

**7.** (Amended) A method of producing a thin film pattern, comprising the steps of
forming a photosensitive composition layer consisting of the silicon-containing photosensitive composition according to any one of claims 1, 3, 4, 5 and 6 on a substrate,
exposing selectively said photosensitive composition layer with an active ray or radiation ray in accordance with a pattern to be formed to form a latent image in the form of pattern, and
developing said photosensitive composition layer on which said latent image is formed with a developer to obtain a thin film pattern.

**8.** (Amended) A protective film for electronic devices formed by using the silicon-containing photosensitive composition according to any one of claims 1, 3, 4, 5 and 6.

**9.** (Amended) A transistor, **characterized by** including a thin film formed by us ing the silicon-containing photosensitive composition according to any one of claims 1, 3, 4, 5 and 6 as a protective film.

**10.** (Amended) A color filter, **characterized by** including a thin film formed by using the silicon-containing photosensitive composition according to any one of claims 1, 3, 4, 5 and 6 as a protective film.

**11.** (Amended) An organic EL device, **characterized by** including a thin film formed by using the silicon-containing photosensitive composition according to any one of claims 1, 3, 4, 5 and 6 as a protective film.

**12.** (Amended) A gate insulating film of a field-effect transistor, **characterized by** consisting of a thin film formed by using the silicon-containing photosensitive composition according to any one of claims 1, 3, 4, 5 and 6.

**13.** (Amended) A field-effect thin film transistor including a semiconductor layer, a source electrode and a drain electrode, which are provided so as to be in contact with the semiconductor layer, a gate electrode, and a gate insulating film placed between the gate electrode and the semiconductor layer, **characterized in that** said gate insulating film is composed of a thin film formed by using the silicon-containing photosensitive composition according to any one of claims 1, 3, 4, 5 and 6.

**14.** (Amended) A field-effect thin film transistor including a semiconductor layer, a source electrode and a drain electrode, which are provided so as to be in contact with the semiconductor layer, a gate electrode, a gate insulating film placed between the gate electrode and the semiconductor layer, and a passivation film, **characterized in that** said passivation film is a thin film formed by using the silicon-containing photosensitive composition according to any one of claims 1, 3, 4, 5 and 6.
